# EUROPEAN PATENT SPECIFICATION

(11) **EP 3 625 442 B1**
(45) Date of publication and mention of the grant of the patent: **02.06.2021**
(21) Application number: 18802844.3
(22) Date of filing: 28.04.2018
(51) Int. Cl.: H02N 2/10, H02N 2/00

(54) **BUCKLING LOOP ROTARY MOTOR**
KNICKSCHLAUFENDREHMOTOR
MOTEUR ROTATIF À BOUCLE DE FLAMBAGE

(30) Priority: 15.05.2017 US 201762506199 P; 16.05.2017 US 201762506828 P; 17.05.2017 US 201762507300 P; 20.05.2017 US 201762509102 P; 15.02.2018 US 201815897334
(43) Date of publication of application: 25.03.2020
(73) Proprietor: Shan, Baoxiang, Hoboken, NJ 07030 (US)
(72) Inventor: Shan, Baoxiang, Hoboken, NJ 07030 (US)
(74) Representative: FRKelly
(86) International application number: PCT/US2018/030059
(87) International publication number: WO 2018/212968

(56) References cited:
- US-A- 5 164 643
- US-A- 5 164 643
- US-A- 5 181 540
- US-A1- 2004 145 267
- US-A1- 2005 162 042
- US-A1- 2005 162 049
- US-A1- 2013 082 427
- US-A1- 2013 220 074
- US-A1- 2015 303 760
- US-B1- 6 392 331
- US-B2- 7 213 547

## Description

### Technical Field

The invention relates to a motor for producing rotary motion using actuation of a flexible band constrained to form a buckled loop, and more particularly, to a buckling loop rotary motor in which actuation of the buckled loop may be by a change of curvature of a portion of the loop through expansion or contraction of a localized portion of the loop. The loop may have an active and a base material, and may be bi-metallic, or have active materials that may be a shape memory alloy (SMA), a bi-morph piezoelectric polymer (PVDF), an electroactive polymer (EAP), a piezoelectric material, an electro-restrictive material or a magneto-restrictive material, or a combination thereof.

### Background Art

The technical problem of creating rotary motion is inherent in the technical field of mechanical engineering, as rotary motion may be used, for instance, to transport objects or to activate mechanisms, such as, but not limited to, mechanical control valves.

Rotary motion that may be driven directly, or indirectly, by means of an electric current, or voltage, is particularly desirable for actuating mechanisms, as this facilitates the integration of the mechanical device with electronic control systems.

A problem with existing electric motors that often arises when they are used to actuate mechanisms such as, but not limited to, control valves, is that existing electronic motors typically operate at rotational speeds that require reduction gearing to match their speed of rotation to that required to most effectively manipulate the valve. Gear mechanisms not only add to the cost and complexity of such systems, but also tend to be the part of the device most prone to failure in harsh or adverse environments, including, but not limited to, extremes of acceleration.

It is, therefore, highly desirable to have a gearless, electrically-driven, rotary motor capable of producing the speeds and torques suitable for actuating mechanical mechanisms such as, but not limited to, control valves. It is also desirable that such gearless motors are compact, and simple to construct.

The relevant existing art includes papers such as, but not limited to, the paper published in The Proceedings of the Royal Society A: Mathematical, Physical and Engineering Sciences, on August 16, 2017 by Hamouche et al. entitled "Multi-parameter actuation of a neutrally stable shell: a flexible gear-less motor".

US 2013/220074 relates to an undulatory structure and methods for the fabrication and use thereof. The undulatory structure includes a buckled sheet and one or more work input elements for deforming the buckled sheet in an undulating manner wherein each point in a series of points on a sinuously-shaped profile of the buckled sheet travels at least partially along a figure eight-shaped path. The undulatory structure can be adapted for use as a solid-state transducer wherein the buckled sheet provides mechanical advantage without appreciable opposition from elastic restoring forces, thereby achieving improved force, displacement and efficiency characteristics.

US 2005/162042 relates to a motor including a support framework and a mechanical movement component moveably mounted to the support framework. An electroactive polymer device having a pair of input electrodes is configured to deform upon application of an electric potential difference across the pair of input electrodes. The electroactive polymer device is mechanically linked to the support framework and to the mechanical movement component so that deformation of the electroactive polymer device causes the movement component to move relative to the support framework. In some motors, the movement component and an electrode fixed in the support framework are driven at different electrical potentials to cause the electroactive polymer device to deform. In some motors a rolled electroactive polymer device is used with a rotating movement component. Such motors enable lightweight, powered vehicles with low radar reflectivity.

US 2005/162049 relates to a motor transmission element including an axle, an expandable circumferential component and multiple rolled electroactive polymer (EAP) devices. The circumferential component is located at a contact radius from the axle for connection to a different rotating body and is mechanically connected to the axle. The rolled EAP devices are mechanically connected to the circumferential component and the axle. Each rolled EAP device has a pair of input electrodes and is configured to deform substantively parallel to a roll longitudinal axis upon application of a voltage difference. Deformation of a rolled EAP device causes a change in the contact radius. A voltage difference that expands the rolled EAP device increases the contact radius, and thereby the circumference of the transmission element. By varying the voltage, a continuously variable ratio can be achieved between a rate of rotation of the transmission element and a rate of rotation of the second body
US5164643 is directed to an apparatus for electrically indexing a rotary component including a housing, a resilient electrically conductive band contained within the housing and connected to the rotary component.

Various implements are known in the art, but fail to address all of the problems solved by the invention described herein. Embodiments of this invention are illustrated in the accompanying drawings and will be described in more detail herein below.

### Disclosure of Invention

An inventive buckling loop rotary motor is disclosed. The present invention is defined in the appended independent claim 1 to which reference should be made. Advantageous features are set out in the appended dependent claims.

In a preferred embodiment, the buckling loop rotary motor may include a rigid stator and an activatable buckling loop that may also serve as a rotor. The stator may, for instance, have a cylindrical, inner surface with a circular cross-section. The buckling loop may, for instance, be made of a combination of a suitably springy, base band and an active band. This buckling loop may be constrained within the cylindrical, inner surface of the rigid stator to form one or more buckles.

In a further preferred embodiment of the present invention, the rotor may be a separate element that may be sized and shaped to conform, in part, to an inner surface of the buckling loop.

The rotary motor may be driven by a stimulus, or force, that may actuate a portion of the activatable, buckling loop. This actuation may result in a localized change of curvature of the buckling loop. This localized change of curvature may propagate along the buckling loop, causing rotation of the rotor with respect to the stator. The direction of rotation may be selected by which portions of the buckling loop are activated, and the axis of rotation is preferably located coaxially with the central axis of cylindrical, inner surface of the stator.

The buckling loop is preferably a continuous ribbon of a uniform thickness and a uniform width and having no end point, with the width being greater than the thickness. The material composition of the buckling loop may, for instance, depend on the method of actuation.

In one embodiment, the buckling loop may have a base band and an active band, with the active band being made of a first, active material and the base band made of a second, base material. The materials may be selected such that, in response to an actuating force, or stimulus, a portion of the first, active material expands in length more than the second, base band material, preferably by at least 0.1%, but in more preferred embodiments by at least 1%. Because the bands are joined together, the resulting stress may effect a localized change of curvature of the activated portion of the buckling loop. The energy of this buckling may then be transformed into rotation of the rotor as the buckled loop changes shape and attempts to minimize its overall energy.

In one preferred embodiment of the present invention, the buckling loop may be a bi-metallic loop, with the active band material having a higher coefficient of linear thermal expansion than the base band material. Such a bi-metallic buckling loop may be actuated by a localized, electrically-controlled, means for generating an activation force that may, for instance, be a means for effecting a change of temperature. The means for effecting a change of temperature may be a heating element such as, but not limited to, an electrical resistor, an electrical diode, a light emitting diode (LED) or a Peltier diode, or some combination thereof, or it may be a cooling element such as, but not limited to, a refrigerant, a liquid nitrogen spray, or a Peltier diode, or some combination thereof.

Suitable materials for the active band of a bi-metallic buckling loop include, but are not limited to, Titanium alloys, stainless steel alloys, copper alloys, aluminum alloy, and combinations thereof.

In such a bi-metallic, buckling loop rotary motor, it may be most energy efficient to activate a buckle at an inflection point of the buckle. In such a device, the means for effecting a change of temperature may, therefore, be fixed on the rotor adjacent to inflection points of one or more of the buckles formed in the buckling loop.

As cooling and heating a buckling loop at the same inflection point may impel the rotor in opposite directions, a heating and a cooling element may be used in conjunction, with, for instance, heating being applied to an inflection point on one side of a buckle while cooling is applied at the corresponding inflection point on the opposite side of the same buckle. Peltier devices may be driven to provide either cooling or heating, so having Peltier devices as the actuating elements may allow for rotor motor that may be driven in opposite rotational directions by changing whether they are driven to heat or to cool.

In a further preferred embodiment of the invention, the buckling loop may be an electroactive polymer (EAP) activated buckling loop rotary motor. In such a motor, the active material may be an EAP such as, but not limited to, an acrylic or a silicone EAP, that act as deformable capacitors, changing their thickness in response to an applied electric field. Such materials typically have elastic energy densities well above the 0.02 J/cm³ to 0.13 J/cm³ range of more conventional piezoelectric ceramic materials. An EAP buckling loop, may, for instance, have an EAP active layer and a suitably springy metal base layer, including metals typically used to make springs such as, but not limited to, Titanium alloys, stainless steel alloys, copper alloys, aluminum alloy, and combinations thereof. A portion of an EAP buckling loop may, for instance, be actuated by an electrical voltage supplied by suitably located electrical contacts. The activated localized portion of the EAP buckling loop, in which the activated EAP material changes shape while the underlying base loop material does not, may result in localized stresses that may cause a local change of curvature of the loop that, when propagated along the loop, may result in rotational motion of the rotor.

In an alternate embodiment, the rotor may have rollers that may contact the buckling loop at the apex point of a buckle, helping maintain the shape of the buckle. Such rollers may also serve as electrical contacts to activate electroactive materials such as, but not limited to, electroactive polymers. Activation of the electroactive material at an inflection point of a buckle by contact point at the apex of the buckle may, for instance, be accomplished using a staggered wiring array on the buckling loop, as described in detail below.

Other materials that may be used as active materials in the active loop of a buckling loop rotary motor include, but are not limited to, electorestrictive materials, magnetorestrictive materials, piezoelectric materials, and shape memory alloys, or some combination thereof.

Therefore, the present invention succeeds in conferring the following, and others not mentioned, desirable and useful benefits and objectives.

It is an object of the present invention to provide a compact, lightweight rotary motor.

It is a further objective of the present invention to provide a gearless, electrically controlled rotary motor suitable for actuating mechanical mechanisms.

### Brief Description of Drawings

Fig. 1A shows a schematic, cross-sectional side view of a single-buckle, buckling loop rotary motor, with a buckling loop constrained within a rigid cylinder, and a close-up view of an activatable region of the loop prior to activation.
**Fig. 1B** shows a schematic, cross-sectional side view of a single-buckle, buckling loop rotary motor, with a buckling loop constrained within a rigid cylinder, and a close-up view of an activatable region of the loop after activation.
**Fig. 2** shows a schematic, cross-sectional side view of a single-buckle, buckling loop rotary motor having a rotor separate from the buckling loop of one embodiment of the present invention.
**Fig. 3** shows a schematic, cross-sectional side view of a single-buckle, buckling loop rotary motor of a further embodiment of the present invention.
**Fig. 4** shows an isometric, cut-away view of a single-buckle buckling loop rotary motor of one embodiment of the present invention.
**Fig. 5** shows a schematic, cross-sectional, side view of a multi-buckle, buckling loop rotary motor of one embodiment of the present invention.
**Fig. 6** shows a schematic, cross-sectional, side view of a multi-buckle, roller stabilized, buckling loop rotary motor of one embodiment of the present invention.
**Fig. 7** shows a schematic, cross-sectional, side view of a multi-buckle, buckling loop rotary motor of another embodiment of the present invention.
**Fig. 8** shows a schematic, cross-sectional, side view of a multi-buckle, roller stabilized, buckling loop rotary motor of further embodiment of the present invention.
**Fig. 9** shows a schematic, top view of a section of a staggered wiring array of one embodiment of the present invention.

### Best Mode for Carrying Out the Invention

The best mode for carrying out the present invention will now be described with reference to the drawings. Identical elements in the various figures are identified with the same reference numerals.

Reference will now be made in detail to various embodiments of the present invention. Such embodiments are provided by way of explanation of the present invention, which is not intended to be limited thereto. In fact, those of ordinary skill in the art may appreciate upon reading the present specification and viewing the present drawings that various modifications and variations can be made thereto.

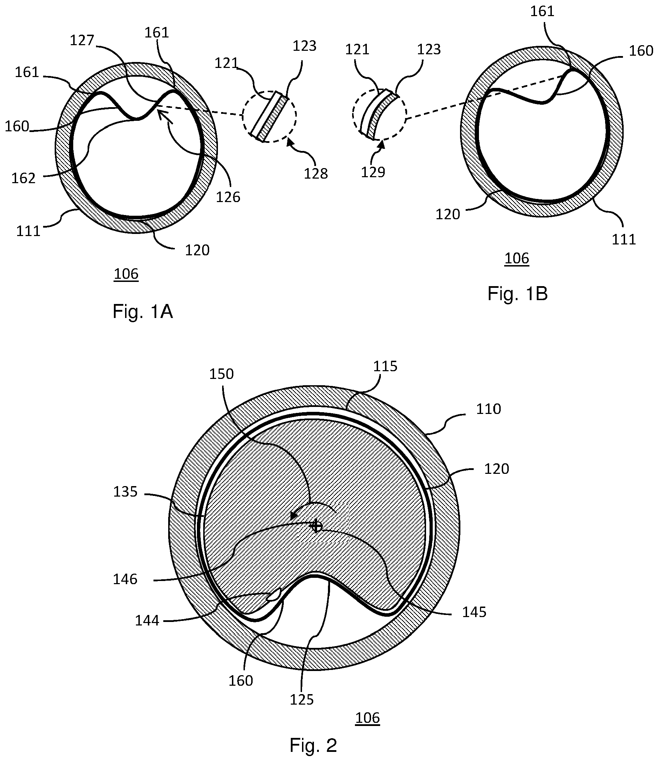

Figure 1A shows a schematic, cross-sectional side view of a single-buckle, motor 106 having a buckling loop 120 constrained within a rigid cylinder 111, and a close-up view 128 of an activatable region of the loop prior to activation.

As shown, the buckling loop 120 may have two regions of buckle/restraint contact 161 at each of which the loop may have a positive, or negative curvature, greater in magnitude than the curvature of the loop where it is merely constrained by the rigid cylinder 111. The single buckle buckling loop 120 may also have a buckle apex 162, and two inflection points 160, at each of which the curvature of the loop is zero.

A portion 127 of the buckling loop 120 may be activated by an actuating force 126. The nature of the actuating force 126 may depend on the composition of the buckling loop 120. This situation may be seen in more detail in a close up of activated portion prior to activation 128. In this view, the portion to be activated is at an inflection point of a buckle, and the loop may be made up of an active band 121 made, at least in part, of a first, active material, and a base band 123 made, at least in part, of a second, base material. If, as shown in Figure 1A, the actuating force 126 is applied at a point of inflection, the activated portion 127 of the loop will have zero curvature prior to application of the actuating force 126.

Figure 1B shows a schematic, cross-sectional side view of the single-buckle, buckling loop motor 106 having a buckling loop 120 constrained within the rigid cylinder 111 after application of the actuating force, and a close-up view 129 of the activated region of the loop after activation.

As seen in Figure 1B, the activated portion of the loop now has a curvature as a result, for instance, of the active band 121 having expanded laterally more than the underlying base band 123 to which it may be attached. This curvature may introduce additional stress and energy into the buckling loop. The buckling loop may then change shape in order to assume a minimum overall energy of the loop. In doing so, the buckling loop may be moved rotationally, thereby acting as the rotor of a single-buckle, buckling loop rotary motor 106.

The examples below show how the nature of the actuating force may depend on the material composition of the active band and the base band. The direction of rotation of the buckled loop may also be shown to depend on the material choice and the nature of the actuating force.

Figure 2 shows a schematic, cross-sectional side view of a single-buckle, buckling loop rotary motor of one embodiment of the present invention.

The single-buckle, buckling loop rotary motor 106 shown in Figure 2 may include a rigid stator 110, a rotor 135 and a buckling loop 120.

In a preferred embodiment, the rigid stator 110 may have a cylindrical, inner surface 115 having a circular cross-section with a central axis 146.

The buckling loop 120 may be constrained within the cylindrical, inner surface 115 of the rigid stator 110 such that the buckle 125 may be formed in the loop. The buckling loop 120 is preferably constructed as continuous ribbon of a uniform thickness, having a uniform width and having no end point. The width of the buckling loop 120 may be greater than its thickness, typically by a factor of at least two, and more preferably by at least a factor of five. Part of the reason for having a greater width to thickness ratio may be to minimize the out-of-plane bending, or buckling, of the loop.

The rotor 135 may be shaped and sized to conform, in part, to the inner surface of the buckling loop 120 when constrained, and buckled, within the cylindrical, inner surface 115 of the rigid stator 110.

In a bi-metallic embodiment of the single-buckle, buckling loop rotary motor 106, the buckling loop 120 may be made of an active band that may have a first, active material that may have a higher coefficient of thermal expansion than that of the base material of which the base band may be made. In such a bi-metallic embodiment, there may be a means 144 for generating an activation force. This may, for instance, be a means for effecting a change of temperature such as, but not limited to, either heating or cooling elements.

It is preferable in such a bi-metallic embodiment that, in response to an actuating force, an activated portion of the first, active material expands in length by at least 0.1%, and even more preferably by at least 1%, more than the second material, thereby effecting a local change of curvature of the actuated portion of the buckling loop.

The active band may, for instance, be made of materials having a coefficient of linear, thermal expansion greater than 5 x10⁻⁶ m/ m/ °C such as, but not limited to, fabric reinforced silicone, fabric reinforced polyurethane, Titanium alloys, stainless steel alloys, copper alloys and aluminum alloys, or combinations thereof. Particularly suitable materials may include Titanium alloys such as, but not limited to, so called Beta titanium alloys, i.e., titanium alloyed in varying amounts with one or more of molybdenum, vanadium, niobium, tantalum, zirconium, manganese, iron, chromium, cobalt, nickel, and copper. This type of alloy may have a strength/modulus of elasticity ratios almost twice that of 18-8 austenitic stainless steel, allowing for larger elastic deflections in springs, and a reduced force per unit displacement. Suitable alloys may include, but are not limited to, "BETA III" (Ti- 11.5 Mo-6.5 Zr-4.6 Sn), Transage 129 (Ti-2Al-11.5V-2Sn-11.3Zr) or Ti-6A1-4V, or some combination thereof.

The base material in such a bi-metallic rotary motor may be any material with a coefficient of linear, thermal expansion that is significantly less than that of the active material. Suitable base materials for a bi-metallic buckling loop include nickel-iron alloys such as, but are not limited to, Invar, NILO alloy 42, Kovar, and Dilver P, or some combination thereof.

When the buckling loop 120 is bi-metallic, with the active and base materials having a difference in linear thermal coefficients of expansion, the actuator elements may be heating elements. An actuator element 140 that is a heating element may, for instance, be attached to the rotor 135 and located such that the heat it supplies stresses the buckle 125 of the buckling loop 120, creating a localized region of curvature. This localized curvature may introduce additional energy into the buckling loop. In order to minimize its overall energy, the buckling loop may change shape. In changing shape, the buckling loop may impel the rotor 135 to rotate in a first direction of rotation 150 about its axis of rotation 145. This axis of rotation 145 may be located coaxially with a central axis 146 of the cylindrical, inner surface 115.

Suitable electrically controlled heating actuator elements 140 include, but are not limited, to, elements made of materials having high electrical resistance and a high melting point, such as, but not limited to, tungsten, nichrome, Kanthal™ FeCrAl alloys, cupronickel, molybdenum disilicide, or devices that emit heat such as, but not limited to, resistors, diodes and light-emitting diodes (LEDs), or some combination thereof.

For optimal use of the heat generated by such heating actuator elements 140, they are preferably placed at, or near, an inflection point 160 of a buckle 125, as that is where the change in curvature they effect may have greatest effect on the rotational torque of the motor.

In a further embodiment of the invention, in a single-buckle, buckling loop rotary motor 106 with a bi-metallic buckling loop 120 having a difference of coefficient of thermal expansions of active and base materials, the actuator elements 140 may be cooling elements. Such cooling elements may, for instance, be a suitable thermoelectric cooling elements such as, but not limited to, well-known Peltier cooling semiconductor devices. Other means of cooling include refrigerants such as, but not limited to, a spray of liquid nitrogen, a supply of cooled water or other liquid, or some combination thereof.

Cooling at an inflection point of a buckle 125 may impel a single-buckle, bi-metallic, buckling loop rotary motor 106 to rotate in a direction that may be opposite to that it would have if that inflection point had been heated. A combination of a heating element and a cooling element may, therefore, be used to advantage, with one element placed at each of the corresponding inflection points of the same buckle. Such a combination of heating and cooling elements on a single bi-metallic buckle may increase the torque that may be applied by the motor.

Furthermore, as a Peltier device may heat or cool, depending on the direction of the flow, if the means 144 for generating an activation force is one or more Peltier devices, they may be used to drive a motor in a first direction of rotation, or in an opposite direction of rotation, depending on which direction an electrical current flows through them. Having the means 144 for generating an activation force be a Peltier activated device may, therefore, allow for the realization of gearless, reversible, single-buckle, bi-metallic buckling loop rotary motors.

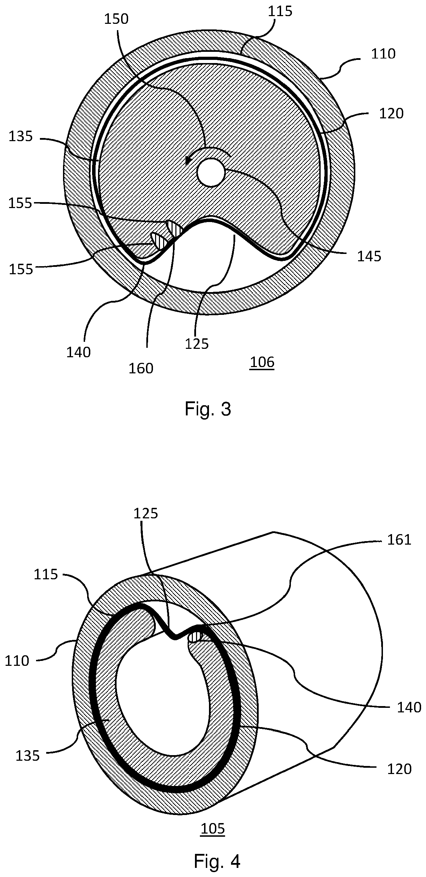

Figure 3 shows a schematic, cross-sectional side view of a single-buckle, buckling loop rotary motor of a further embodiment of the present invention.

The single-buckle, buckling loop rotary motor 106 shown in Figure 3 may include a rigid stator 110 with a cylindrical, inner surface 115 having a circular cross-section in which a buckling loop 120 may be constrained to form a buckles 125, and a rotor 135, shaped and sized to fit, in part the inner contour of the constrained buckling loop.

However, in the embodiment depicted in Figure 3, the buckling loop 120 may have a first, active material that is an electroactive polymer (EAP) and in which the actuating force is supplied, or activated, by means of an electrical force such as, but not limited to, an electrical current, voltage or an electrostatic charge. The electrical force may, for instance, be supplied via one or more electrical contacts 155.

The electroactive polymer (EAP) preferably has a dielectric constant of at least 2, measured at room temperature, i.e., at 293 K (20°C or 68 °F), and 1 KHz. (Note: for scientific calculations using the absolute temperature scale, room temperature may sometimes be taken as 300 K to simplify the calculation). The first, active material may also/or instead, be selected to have an energy density greater than or equal to 0.02 J/cm³, and more preferably to have an energy density greater than or equal to 0.4 J/cm³.

Particularly suitable electroactive polymers for use in rotary motors include, but are not limited to, an acrylic or a silicone, or a combination thereof. One example of a commercially available electroactive polymer (EAP) suitable for use in a buckling loop rotary motor is 3M® VHB (Very High Bonding) tape supplied by the 3M Company, Maplewood, Minnesota.

In the EAP buckling loop 120, the base material is preferably a suitably springy material such as, but not limited to, a fabric reinforced silicone, a fabric reinforced polyurethane, a Titanium alloy, a stainless steel alloy, a copper alloy or an aluminum alloy, or a combination thereof. Further embodiments may use a base material that may be a highly elastic material. A highly elastic metal may, for instance, have a yield strain greater than 0.1% and more preferably, a yield strain greater than 1%.

In a preferred embodiment of such an electroactive, single-buckle, buckling loop rotary motor 106, there may also be one or more electrical contacts 155 that may be located on the rotor 135 such that they may supply the necessary electrical voltage and current to a region of the buckling loop 120 in a vicinity of one of the inflection points 160 of the buckles 125. This voltage may then cause that region of the buckling loop 120 to develop a stress resulting in imparting a localized curvature to the loop that may impel the rotor 135 to rotate in a first direction of rotation 150 about the axis of rotation 145.

In yet further embodiments of the invention, the active band of the buckling loop 120 may, for instance, be made wholly, or in part, of an active material that is an electroactive material such as, but not limited to, a polyvinylidene fluoride (PVDF) or an Iodine doped polyacetylene, or a combination thereof.

In an alternate embodiment of the invention, the active band of the buckling loop 120 may instead be made wholly, or in part, of an active material that may be magnetostrictive and may have a magnetostrictive coefficient greater than 50 microstrains. Regions of such a buckling loop 120 may be activated by suitable magnetic sources that may, for instance, be placed on the rotor 135 so as to activate one of the inflection points 160 of the buckle 125.

A suitable magnetorestictive material having a magnetostrictive coefficient greater than 50 microstrains may be a material such as, but not limited to, Terfenol-D, or Galfenol. (Terfenol-D stands for Ter for terbium, Fe for iron, NOL for Naval Ordnance Laboratory, and D for dysprosium). It is a material that may exhibit about 2,000 microstrains in a field of 2 kOe (160 kA/m) at room temperature. A suitable source of magnetic flux may be a magnet such as, but not limited to, a suitably strong rare-earth permanent magnet, or an electro-magnet or a combination thereof.

The source of magnetic flux may cause a region of the buckling loop 120 to impart a localized stress to the loop that may cause localized bending of the loop and so impel the rotor 135 to rotate in a first direction of rotation 150 about the axis of rotation 145.

Figure 4 shows an isometric, cut-away view of a single-buckle buckling loop rotary motor of one embodiment of the present invention.

The inventive device depicted in Figure 4 includes a rigid stator 110 having a cylindrical, inner surface 115 having a circular cross-section. A buckling loop 120 is shown constrained by that cylindrical, inner surface 115 to form a buckle 125 that may be actuated by an actuating force supplied via an actuator element 140 situated on a rotor 135.

In the embodiment of Figure 4, the buckling loop 120 may, for instance, be a single layer loop having an active material such as, but not limited to, a two-way shape memory active material. Such a material effectively remembers two different shapes - one that it assumes at a higher temperature and one that it assumes at a lower temperature. Materials that exhibit a two-way shape memory include, but are not limited to, nickel/titanium alloys, such as Nitinol.

The two-way shape memory active material may, for instance, be actuated by a means for generating an activation force such as one or more actuator elements 140 that may be heating or cooling elements, or a combination thereof.

The two-way shape memory active material may, for instance, have a greater curvature at a lower temperature and less of a curvature at a higher temperature, i.e., it may, for instance, be bent when cold and straight when hot. For such a material, a most advantageous location for an actuator element 140 that is a heating or cooling element may be at, or close to, a region of buckle/restraint contact 161.

Suitable heating elements include electrically heated elements such as, but not limited to, a resistance wire, resistors, diodes, or light emitting diodes, or some combination thereof. Other heating elements include ignited flammable materials such as, but not limited to, burning candles, or lighted nozzles of flammable gases, or some combination thereof. Further heating elements include concentrated light such as, but not limited to, focused laser light, focused solar light, focused light from an infrared source, or some combination thereof.

Suitable cooling elements include, but are not limited to, Peltier devices, which may also, or instead, act as heating elements. Other cooling elements include, but are not limited to, supplies of cooled refrigerants, supplies of cooled liquids, sprays of cooled liquids, or sprays of liquid nitrogen, or some combination thereof.

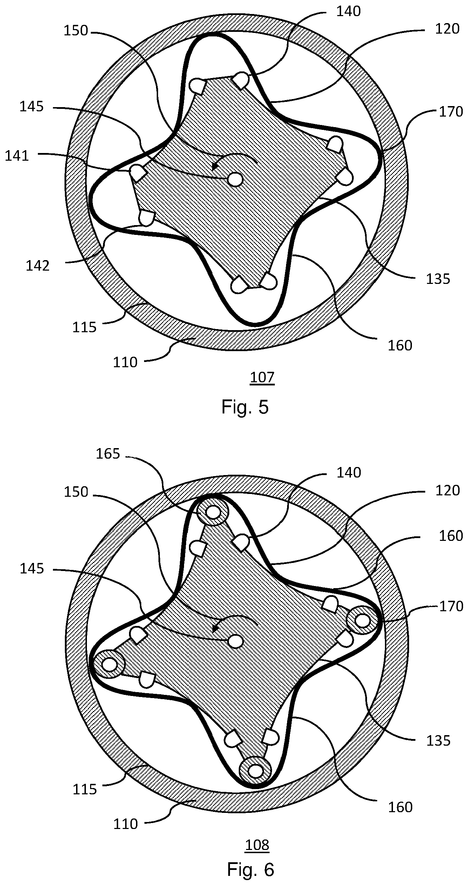

Figure 5 shows a schematic, cross-sectional, side view of a multi-buckle, buckling loop rotary motor of one embodiment of the present invention.

The multi-buckle, buckling loop rotary motor 107 may have a rigid stator 110 with a cylindrical, inner surface 115 having a circular cross-section, and a rotor 135. Located between the rotor 135 and the cylindrical, inner surface 115 may be a buckling loop 120 constrained to form a multiplicity of buckles 125. In the embodiment of Figure 5, there the buckling loop 120 is shown constrained to form four buckles 125.

In a bi-metallic embodiment of the multi-buckle, buckling loop rotary motor 107, the buckling loop 120 may be made of an active band that may have an active material that may have a higher coefficient of thermal expansion than that of the base material of which the base band may be made. In such a bi-metallic embodiment, there may be actuator elements 140 that may be either heating or cooling elements.

The bi-metallic buckling loop 120 may, for instance, be made with an active material that may have a coefficient of linear, thermal expansion greater than 5 x10⁻⁶ m/ m/ °C. Such materials include, but are not limited to, fabric reinforced silicones, fabric reinforced polyurethanes, Titanium alloys, stainless steel alloys, copper alloys, aluminum alloy, and combinations thereof. Particularly suitable active materials may include Titanium alloys such as, but not limited to, so called Beta titanium alloys, i.e., titanium alloyed in varying amounts with one or more of molybdenum, vanadium, niobium, tantalum, zirconium, manganese, iron, chromium, cobalt, nickel, and copper. This type of alloy may have a strength/modulus of elasticity ratios almost twice that of 18-8 austenitic stainless steel, allowing for larger elastic deflections in springs, and a reduced force per unit displacement. Suitable alloys may include, but are not limited to, "BETA III" (Ti-11.5 Mo-6.5 Zr-4.6 Sn), Transage 129 (Ti-2Al-11.5V-2Sn-11.3Zr) or Ti-6Al-4V, or some combination thereof.

In such a thermally activated, bi-metallic embodiment of the buckling loop rotary motor, there may be either heating or cooling elements 140, that may be used to activate localized regions of the loop. These actuating, heating or cooling, elements are each preferably located on the rotor 135 opposite one of the two inflection points 160 of one of the buckles 125.

A heating element 141 placed on the rotor 135 opposite a first inflection point of a buckles 125 may, when heated, induce a stress in the buckling loop 120 that may cause a localized change of curvature of the loop and so impel the rotor 135 to turn in a first direction of rotation 150 about an axis of rotation 145 of the rotor.

Similarly, cooling element 142 placed on the rotor 135 opposite a second, adjacent inflection point of that same buckles 125, may, when cooled, induce a stress in the buckling loop 120 that may cause a localized change of curvature of the loop and so impel the rotor 135 to turn in the same, first direction of rotation 150 about the axis of rotation 145 of the rotor.

In this way, pairs of heating elements 141 and cooling elements 142 may be used together to significantly increase the stresses applied to the buckling loop 120 and therefore increase the torque of the buckling loop rotary motor.

If the positions of the heating element 141 and the cooling elements 142 are switched, the rotor 135 may then be impelled to turn in an opposite direction to the first direction of rotation 150, thereby facilitating a reversible, but gearless, motor. As Peltier devices may be either heating or cooling devices, depending on the direction of the electrical current flowing through them, switching an actuator element 140 may be accomplished electronically by switching the direction of current flow through them.

Figure 6 shows a schematic, cross-sectional, side view of a multi-buckle, roller stabilized, buckling loop rotary motor of one embodiment of the present invention.

In the multi-buckle, roller stabilized, buckling loop rotary motor 108 depicted in Figure 6, in addition to the rigid stator 110 with a cylindrical, inner surface 115 having a circular cross-section, the buckling loop 120 constrained within the cylindrical, inner surface 115, and the rotor 135 contained within the buckling loop 120, there are one or more rollers 165. The rollers 165 may be rotatably attached to the rotor 135 and may serve to assist in constraining the buckling loop 120 to form the required buckles 125, by, for instance, being situated to contact the buckling loop at an inner surface of an apex 170 of one or more of said buckles.

In a bi-metallic embodiment, the buckling loop 120 may have an active material having a coefficient of linear, thermal expansion greater than the base material, as described in more detail above regarding other embodiments of thermally activated, bi-metallic buckling loop rotary motors.

Similarly, the actuator elements 140 suppling the actuating force to the thermally activated bi-metallic loop may be either heating or cooling elements. These are each preferably located on the rotor 135 opposite one of the two inflection points 160 of one of the buckles 125, as described in more detail above, regarding other embodiments of thermally activated buckling loop rotary motors.

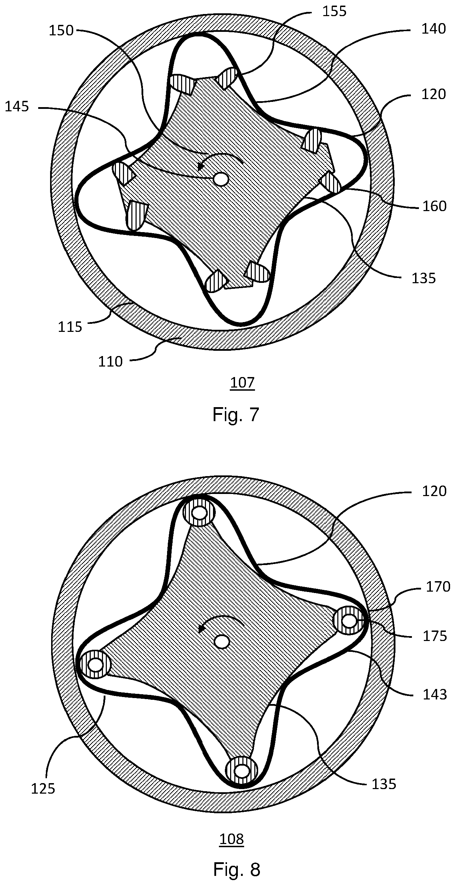

Figure 7 shows a schematic, cross-sectional, side view of a multi-buckle, buckling loop rotary motor of another embodiment of the present invention, in which a buckling loop 120 is constrained within the cylindrical, inner surface 115 having a circular cross-section of a rigid stator 110 and encompasses a rotor 135.

The multi-buckle, buckling loop rotary motor 107 depicted in Figure 7 may have an electroactive buckling loop 120. Such a buckling loop 120 may, for instance, be made of an active material that is an electroactive polymer (EAP) and in which the actuating force is supplied by electricity in the form of, for instance, an electric current, an electric voltage or an electrostatic charge, or some combination thereof. The electricity may, for instance, be supplied via one or more electrical contacts 155 that may be a part of the rotor 135. As with other electro-active embodiments described above, the actuator elements 140 are preferable turned on when they are at an inflection point of a buckle, so that the stress induced in the buckling loop 120 may be more effective in impelling the rotor 135 to rotate in a first direction of rotation 150 about the axis of rotation 145 of the rotor.

The first, active material of such an electroactive buckling loop may, for instance, be selected to one having an energy density greater than or equal to 0.02 J/cm³, and more preferably to one having an energy density greater than or equal to 0.4 J/cm³.

Figure 8 shows a schematic, cross-sectional, side view of a multi-buckle, roller stabilized, buckling loop rotary motor of further embodiment of the present invention.

In the electro-active embodiment of a multi-buckle, roller stabilized, buckling loop rotary motor 108 depicted in Figure 8, the rollers may now be electrical contact roller 175 and be the means by which the appropriate electrical current, charges and/or voltages are supplied to the actuate the appropriate regions of the buckling loop 120.

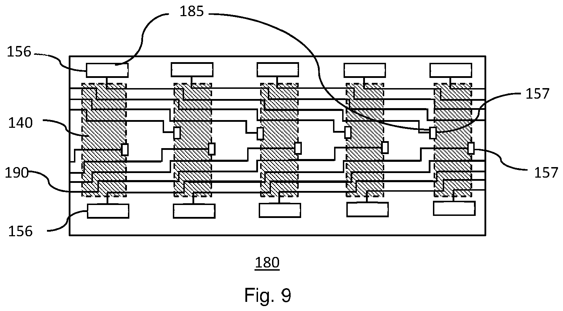

In order for a contact made by the electrical contact roller 175 at an apex 170 of a buckle 125 to actuate an activatable region 143 at an inflection point, a staggered wiring array may need to be printed, or otherwise associated with the buckling loop 120. One embodiment of such a staggered wiring array is depicted in Figure 9.

Figure 9 shows a schematic, top view of a section of a staggered wiring array of one embodiment of the present invention.

The staggered wiring array 180 may, for instance, have actuator elements 140 arranged on one surface of a buckling loop, and supply electrical contacts 156 arranged on the other surface. The supply electrical contacts 156 may be joined to actuator electrical contacts 157 via appropriate electrical contact paths 190, and the actuator electrical contact 157 may extend through the depth of the buckling loop, so that wiring on one surface of the loop may then be extended through to contact the actuator elements 140 that may be situated on the other surface of the loop. By suitable arrangement of the wiring, corresponding 185 supply contacts and actuator contacts may allow an electrical voltage applied to the contact at an apex of a buckle to activate an actuator element 140 located at an inflection point of that buckle.

Although this invention has been described with a certain degree of particularity, it is to be understood that the present disclosure has been made only by way of illustration and that numerous changes in the details of construction and arrangement of parts may be resorted to without departing from the scope of the invention.

### Industrial Applicability

The present invention has applicability in many industries in which electrically controlled, rotary motion is desired or required. For instance, in industries as diverse as robotics, chemical processing and oil exploration, there is a requirement for valves controlled by precise, high torque, low speed, electrical rotary motors that may be met by the present invention.

## Claims

1. A buckling loop rotary motor (106), comprising:
a rigid stator (110), comprising a cylindrical inner surface (115) having a circular cross-section;
a buckling loop (120), constrained within said cylindrical inner surface to form one or more buckles; and **characterized by**
means (144) for generating an activation force within said buckling loop, said activation force effecting a change of shape of said one or more buckles, thereby impelling said buckling loop to rotate with respect to said rigid stator about an axis of rotation (145) located substantially coaxially with a central axis (146) of said cylindrical inner surface.

2. The buckling loop rotary motor of claim 1, wherein said buckling loop comprises a continuous ribbon of a uniform thickness and a uniform width and having no end point, and, wherein, said width is greater than said thickness.

3. The buckling loop rotary motor of claim 1, further comprising:
a rotor (135), sized and shaped to conform, in part, to an inner surface of said buckling loop, and, wherein, said change of shape of said one or more buckles further impels said rotor to rotate with respect to said rigid stator about said axis of rotation located substantially coaxially with said central axis of said cylindrical, inner surface.

4. The buckling loop rotary motor of claim 3, further comprising one or more rollers (165) rotatably attached to said rotor, and situated to contact said buckling loop at an inner surface of an apex of one or more of said buckles.

5. The buckling loop rotary motor of claim 1, wherein said buckling loop comprises a base band (123) and an active band (121), and wherein said active band is comprised of a first, active material and said base band is comprised of a second, base material and wherein, in response to said actuating force, an activated portion of said first, active material changes in length by at least 0.1% more, or less, than said second base material, thereby effecting a change of curvature of said actuated portion of said buckling loop.

6. The buckling loop rotary motor of claim 3, wherein said buckling loop comprises a base band (123) and an active band (121), and wherein said active band is comprised of a first, active material and said base band is comprised of a second, base material and wherein, in response to said actuating force, an activated portion of said first, active material changes in length by at least 0.1% more, or less, than said second base material, thereby effecting a change of curvature of said actuated portion of said buckling loop.

7. The buckling loop rotary motor of claim 4, wherein said buckling loop comprises a base band (123) and an active band (121), and wherein said active band is comprised of a first, active material and said base band is comprised of a second, base material and wherein, in response to said actuating force, an activated portion of said first, active material changes in length by at least 0.1% more, or less, than said second base material, thereby effecting a change of curvature of said actuated portion of said buckling loop.

8. The buckling loop rotary motor of claims 1, 2, 3, 4, 5, 6 or 7, wherein, said buckling loop comprises an electroactive polymer.

9. The buckling loop rotary motor of claims 1, 2, 3, 4, 5, 6 or 7, wherein, said buckling loop comprises a two-way shape memory active material.

10. The buckling loop rotary motor of claims 1, 2, 3, 4, 5, 6 or 7, wherein, said buckling loop comprises Nitinol.

11. The buckling loop rotary motor of claims 3, 4, 6 or 7, wherein said means for generating said activation force comprises a means (139) for effecting a change of temperature, said means being located on said rotor adjacent an inflection point (160) of said one or more buckles.

12. The buckling loop rotary motor of claims 3, 4, 6 or 7, wherein said means for generating said activation force comprises a light emitting diode (LED) located on said rotor adjacent an inflection point (160) of said one or more buckles.

13. The buckling loop rotary motor of claims 3, 4, 6 or 7, wherein said means for generating said activation force comprises a Pelitier device located on said rotor adjacent an inflection point (160) of said one or more buckles.

14. The buckling loop rotary motor of claims 1, 2, 3, 4, 5, 6 or 7, wherein, said means for generating said activation force is configured to be activated electrically via one or more electrical contacts (155).

15. The buckling loop rotary motor of claims 1, 2, 3, 4, 5, 6 or 7, further comprising a staggered wiring array (180) formed such that one or more contact points at an apex (170) of one or more of said buckles is configured to activate said buckling loop at one or more of said inflection points of one of said buckles.

## Patentansprüche

1. Knickschlaufendrehmotor (106), umfassend:
einen starren Stator (110), der eine zylindrische Innenfläche (115) umfasst und der einen kreisförmigen Querschnitt aufweist;
eine Knickschlaufe (120), die innerhalb der zylindrischen Innenfläche gehalten wird, um einen oder mehrere Knicke zu bilden; und **gekennzeichnet durch**
eine Einrichtung (144) zum Erzeugen einer Aktivierungskraft innerhalb der Knickschlaufe, wobei die Aktivierungskraft eine Formänderung des einen oder der mehreren Knicke bewirkt, wodurch sie die Knickschlaufe dazu antreibt, sich in Bezug auf den starren Stator um eine Rotationsachse (145), die im Wesentlichen koaxial mit der Mittelachse (146) der zylindrischen Innenfläche angeordnet ist, zu drehen.

2. Knickschlaufendrehmotor nach Anspruch 1, wobei die Knickschlaufe ein durchgängiges Band einer einheitlichen Dicke und einer einheitlichen Breite umfasst, das keinen Endpunkt aufweist, und wobei die Breite größer als die Dicke ist.

3. Knickschlaufendrehmotor nach Anspruch 1, ferner Folgendes umfassend:
einen Rotor (135), der so bemessen und geformt ist, dass er zum Teil mit einer Innenfläche der Knickschlaufe übereinstimmt, und wobei die Formänderung des einen oder der mehreren Knicke ferner den Rotor antreibt, sich in Bezug auf den starren Stator um die Rotationsachse, die im Wesentlichen koaxial mit der Mittelachse der zylindrischen Innenfläche angeordnet ist, zu drehen.

4. Knickschlaufendrehmotor nach Anspruch 3, ferner eine oder mehrere Rollen (165) umfassend, die drehbar an dem Rotor angebracht sind und so angeordnet sind, dass sie die Knickschlaufe an einer Innenfläche eines Scheitelpunkts des einen oder der mehreren Knicke berührt.

5. Knickschlaufendrehmotor nach Anspruch 1, wobei die Knickschlaufe einen Basisstreifen (123) und einen aktiven Streifen (121) umfasst und wobei der aktive Streifen aus einem ersten, aktiven Material besteht und der Basisstreifen aus einem zweiten, grundlegenden Material besteht, und wobei sich als Reaktion auf die Aktivierungskraft ein aktivierter Abschnitt des ersten, aktiven Materials der Länge nach um mindestens 0,1 % mehr oder weniger als das zweite Basismaterial ändert, wodurch eine Änderung der Krümmung des aktivierten Abschnitts der Knickschlaufe bewirkt wird.

6. Knickschlaufendrehmotor nach Anspruch 3, wobei die Knickschlaufe einen Basisstreifen (123) und einen aktiven Streifen (121) umfasst und wobei der aktive Streifen aus einem ersten, aktiven Material besteht und der Basisstreifen aus einem zweiten, grundlegenden Material besteht, und wobei sich als Reaktion auf die Aktivierungskraft ein aktivierter Abschnitt des ersten, aktiven Materials der Länge nach um mindestens 0,1 % mehr oder weniger als das zweite Basismaterial ändert, wodurch eine Änderung der Krümmung des aktivierten Abschnitts der Knickschlaufe bewirkt wird.

7. Knickschlaufendrehmotor nach Anspruch 4, wobei die Knickschlaufe einen Basisstreifen (123) und einen aktiven Streifen (121) umfasst und wobei der aktive Streifen aus einem ersten, aktiven Material besteht und der Basisstreifen aus einem zweiten, grundlegenden Material besteht, und wobei sich als Reaktion auf die Aktivierungskraft ein aktivierter Abschnitt des ersten, aktiven Materials der Länge nach um mindestens 0,1 % mehr oder weniger als das zweite Basismaterial ändert, wodurch eine Änderung der Krümmung des aktivierten Abschnitts der Knickschlaufe bewirkt wird.

8. Knickschlaufendrehmotor nach den Ansprüchen 1, 2, 3, 4, 5, 6 oder 7, wobei die Knickschlaufe ein elektroaktives Polymer umfasst.

9. Knickschlaufendrehmotor nach den Ansprüchen 1, 2, 3, 4, 5, 6 oder 7, wobei die Knickschlaufe ein aktives Material mit Zweiweg-Formgedächtniseffekt umfasst.

10. Knickschlaufendrehmotor nach den Ansprüchen 1, 2, 3, 4, 5, 6 oder 7, wobei die Knickschlaufe Nitinol umfasst.

11. Knickschlaufendrehmotor nach den Ansprüchen 3, 4, 6 oder 7, wobei die Einrichtung zum Erzeugen der Aktivierungskraft eine Einrichtung (139) zum Bewirken einer Temperaturänderung umfasst, wobei die Einrichtung an dem Rotor angrenzend an einen Wendepunkt (160) des einen oder der mehreren Knicke angeordnet ist.

12. Knickschlaufendrehmotor nach den Ansprüchen 3, 4, 6 oder 7, wobei die Einrichtung zum Erzeugen der Aktivierungskraft eine Lichtemissionsdiode (LED) umfasst, die an dem Rotor angrenzend an einen Wendepunkt (160) des einen oder der mehreren Knicke angeordnet ist.

13. Knickschlaufendrehmotor nach den Ansprüchen 3, 4, 6 oder 7, wobei die Einrichtung zum Erzeugen der Aktivierungskraft eine Pelitier-Vorrichtung umfasst, die an dem Rotor angrenzend an einen Wendepunkt (160) des einen oder der mehreren Knicke angeordnet ist.

14. Knickschlaufendrehmotor nach den Ansprüchen 1, 2, 3, 4, 5, 6 oder 7, wobei die Einrichtung zum Erzeugen der Aktivierungskraft so konfiguriert ist, dass sie elektrisch über einen oder mehrere elektrische Kontakte (155) aktiviert wird.

15. Knickschlaufendrehmotor nach den Ansprüchen 1, 2, 3, 4, 5, 6 oder 7, ferner ein versetztes Verdrahtungsfeld (180) umfassend, das so ausgebildet ist, dass ein oder mehrere Kontaktpunkte an einem Scheitelpunkt (170) des einen oder der mehreren Knicke so konfiguriert sind, dass sie die Knickschlaufe an einem oder mehreren der Wendepunkt eines der Knicke aktivieren.

## Revendications

1. Moteur rotatif à boucle de flambage (106), comprenant :
un stator rigide (110), comprenant une surface interne cylindrique (115) ayant une section transversale circulaire ;
une boucle de flambage (120), contrainte au sein de ladite surface interne cylindrique pour former un ou plusieurs flambages ; et **caractérisé par**
un moyen (144) pour générer une force d'activation au sein de ladite boucle de flambage, ladite force d'activation effectuant un changement de forme desdits un ou plusieurs flambages, forçant ainsi ladite boucle de flambage à entrer en rotation par rapport audit stator rigide autour d'un axe de rotation (145) situé sensiblement coaxialement avec un axe central (146) de ladite surface interne cylindrique.

2. Moteur rotatif à boucle de flambage selon la revendication 1, dans lequel ladite boucle de flambage comprend un ruban continu d'une épaisseur uniforme et d'une largeur uniforme et n'ayant pas de point d'extrémité, dans lequel ladite largeur est supérieure à ladite épaisseur.

3. Moteur rotatif à boucle de flambage selon la revendication 1, comprenant en outre :
un rotor (135), dimensionné et formé pour se conformer, en partie, à une surface interne de ladite boucle de flambage, et, dans lequel, ledit changement de forme desdits un ou plusieurs flambages force en outre ledit rotor à entrer en rotation par rapport audit stator rigide autour dudit axe de rotation situé sensiblement coaxialement avec ledit axe central de ladite surface interne cylindrique.

4. Moteur rotatif à boucle de flambage selon la revendication 3, comprenant en outre un ou plusieurs galets (165) fixés de manière rotative audit rotor, et situés pour entrer en contact avec ladite boucle de flambage au niveau d'une surface interne d'un sommet d'un ou plusieurs desdits flambages.

5. Moteur rotatif à boucle de flambage selon la revendication 1, dans lequel ladite boucle de flambage comprend une bande de base (123) et une bande active (121), et dans lequel ladite bande active est composée d'un premier matériau actif et ladite bande de base est composée d'un second matériau de base et dans lequel, en réponse à ladite force d'actionnement, une partie activée dudit premier matériau actif change en longueur d'au moins 0,1 % ou plus, ou moins, que ledit second matériau de base, effectuant ainsi un changement de courbure de ladite partie actionnée de ladite boucle de flambage.

6. Moteur rotatif à boucle de flambage selon la revendication 3, dans lequel ladite boucle de flambage comprend une bande de base (123) et une bande active (121), et dans lequel ladite bande active est composée d'un premier matériau actif et ladite bande de base est composée d'un second matériau de base et dans lequel, en réponse à ladite force d'actionnement, une partie activée dudit premier matériau actif change en longueur d'au moins 0,1 % ou plus, ou moins, que ledit second matériau de base, effectuant ainsi un changement de courbure de ladite partie actionnée de ladite boucle de flambage.

7. Moteur rotatif à boucle de flambage selon la revendication 4, dans lequel ladite boucle de flambage comprend une bande de base (123) et une bande active (121), et dans lequel ladite bande active est constituée d'un premier matériau actif et ladite bande de base est constituée d'un second matériau de base et dans lequel, en réponse à ladite force d'actionnement, une partie activée dudit premier matériau actif change en longueur d'au moins 0,1 % ou plus, ou moins, que ledit second matériau de base, effectuant ainsi un changement de courbure de ladite partie actionnée de ladite boucle de flambage.

8. Moteur rotatif à boucle de flambage selon les revendications 1, 2, 3, 4, 5, 6 ou 7, dans lequel ladite boucle de flambage comprend un polymère électroactif.

9. Moteur rotatif à boucle de flambage selon les revendications 1, 2, 3, 4, 5, 6 ou 7, dans lequel ladite boucle de flambage comprend un matériau actif à mémoire de forme à deux voies.

10. Moteur rotatif à boucle de flambage selon les revendications 1, 2, 3, 4, 5, 6 ou 7, dans lequel ladite boucle de flambage comprend du nitinol.

11. Moteur rotatif à boucle de flambage selon les revendications 3, 4, 6 ou 7, dans lequel ledit moyen pour générer ladite force d'activation comprend un moyen (139) pour effectuer un changement de température, ledit moyen étant situé sur ledit rotor adjacent à un point d'inflexion (160) desdits un ou plusieurs flambages.

12. Moteur rotatif à boucle de flambage selon les revendications 3, 4, 6 ou 7, dans lequel ledit moyen pour générer ladite force d'activation comprend une diode électroluminescente (LED) située sur ledit rotor adjacent à un point d'inflexion (160) desdits un ou plusieurs flambages.

13. Moteur rotatif à boucle de flambage selon les revendications 3, 4, 6 ou 7, dans lequel ledit moyen pour générer ladite force d'activation comprend un dispositif Peltier situé sur ledit rotor adjacent à un point d'inflexion (160) desdits un ou plusieurs flambages.

14. Moteur rotatif à boucle de flambage selon les revendications 1, 2, 3, 4, 5, 6 ou 7, dans lequel ledit moyen pour générer ladite force d'activation est configuré pour être activé électriquement via un ou plusieurs contacts électriques (155) .

15. Moteur rotatif à boucle de flambage selon les revendications 1, 2, 3, 4, 5, 6 ou 7, comprenant en outre un réseau de câblage étalé (180) formé de sorte qu'un ou plusieurs points de contact au niveau d'un sommet (170) d'un ou plusieurs desdits flambages sont configurés pour activer ladite boucle de flambage au niveau d'un ou plusieurs desdits points d'inflexion de l'un desdits flambages.
